(19) Europäisches Patentamt
European Patent Office
Office européen des brevets

(11) **EP 1 959 251 A1**

(12) **EUROPEAN PATENT APPLICATION**
published in accordance with Art. 158(3) EPC

(43) Date of publication:
**20.08.2008 Bulletin 2008/34**

(21) Application number: **06833953.0**

(22) Date of filing: **05.12.2006**

(51) Int Cl.:
*G01N 21/956* (2006.01)     *H01L 21/66* (2006.01)
*H04N 5/335* (2006.01)

(86) International application number:
**PCT/JP2006/324198**

(87) International publication number:
**WO 2007/066628 (14.06.2007 Gazette 2007/24)**

(84) Designated Contracting States:
**DE FR**

(30) Priority: **06.12.2005 JP 2005352765**

(71) Applicant: **Shibaura Mechatronics Corporation**
**Yokohama-shi,**
**Kanagawa 247-8610 (JP)**

(72) Inventors:
• **HAYASHI, Yoshinori**
  **Yokohama-shi Kanagawa 2478560 (JP)**

• **MORI, Hideki**
  **Yokohama-shi Kanagawa 2478560 (JP)**

(74) Representative: **Ward, James Norman**
**HASELTINE LAKE**
**5th Floor, Lincoln House**
**300 High Holborn**
**London WC1V 7JH (GB)**

(54) **APPEARANCE INSPECTING DEVICE**

(57)     [PROBLEMS]To provide a visual inspection system able to greatly suppress the increase of the amount of processing and detect scratches or other defects of the surface of an object being inspected by a suitable resolution and able to judge the state of formation of films on that object surface.

[MEANS FOR SOLUTION]A system having an imaging unit 20 provided with a plurality of line sensors 22R, 22G, and 22B differing in color sensitivity characteristics and a processing unit 50, the processing unit 50 having a pixel data acquiring means (S14) acquiring pixel density data from a density signal from a reference line sensor by a first pixel density and pixel density data from density signals from the line sensors other than the reference line sensor by a second pixel density lower than the first pixel density and generating information showing the state of the object surface based on the pixel density data acquired by the first pixel density and the pixel density data acquired by the second pixel density.

【FIG.5】

## Description

### TECHNICAL FIELD

The present invention relates to a visual inspection system inspecting the external appearance of the surface of an object being inspected such as the peripheral end face of a semiconductor wafer.

### BACKGROUND ART

In the past, an inspection system for detecting a defect at a peripheral end face of a semiconductor wafer (visual inspection system) has been proposed (for example, Patent Document 1). This inspection system generates information showing the state of the peripheral end face of the semiconductor wafer, for example, image information showing that peripheral end face and information showing defects, scratches, foreign matter, etc. at that peripheral end face based on a density signal obtained for each pixel when scanning the peripheral end face of the semiconductor wafer being inspected by a single line sensor. According to this inspection system, it can be judged if there are relief shapes at the peripheral end face of the semiconductor wafer and what kind of defects etc. there are at that peripheral end face.

By the way, the process of production of a semiconductor wafer includes a film-forming step of an oxide film, nitride film, polycrystalline silicon film, aluminum film, etc., a photolithographic step of coating, exposing, developing, etc. a photosensitive material (resist), an etching step of partially removing a resist film formed on the semiconductor wafer in the photolithographic step, etc. If it were possible to learn the states of the various types of films formed on the surface of a semiconductor wafer by such a process, it would be possible to judge the suitability of the conditions of the film-forming step, photolithographic step, and etching step. For this reason, it is demanded to detect scratches or other defects and the states of the films on the surface of a semiconductor wafer.

By the way, in the above-mentioned conventional inspection system, it is not possible to differentiate the states of scratches or other defects (relief parts) and the shapes of various types of films in an image obtained from a density signal from a single line sensor since they are expressed by densities in the same ways. Further, the various films cannot be differentiated from each other. Therefore, since the various films formed on the surface of a semiconductor wafer can be differentiated by their tinges, it may be considered to use a color sensor to scan the surface of a semiconductor being inspected (for example, the peripheral end face). For example, it is possible to use three line sensors having color sensitivity characteristics of the three primary colors of light (red, green, and blue) respectively to scan the surface of the semiconductor wafer being inspected and judge the state of the surface of the semiconductor wafer (state of scratches etc. and state of film formation) from the state of the density of the image or state of color distribution obtained based on the density signals output from the three line sensors at the time of the scan.

Patent Document 1: Japanese Patent Publication (A) No. 2000-114329

### DISCLOSURE OF THE INVENTION

### PROBLEMS TO BE SOLVED BY THE INVENTION

However, since three line sensors are used, the amount of processing for acquiring pixel density data from the density signals for all pixels from all line sensors ends up becoming three times the case of a single line sensor if simply calculated. For this reason, the required memory capacity ends up increasing and the processing time ends up increasing. It would conceivably be possible to suppress the increase of the amount of processing by lowering the resolution of the line sensors, but if doing this, the resolution of detection of scratches or other defects on the surface of the object being inspected would also end up falling.

The present invention was made in consideration of this situation and provides a visual inspection system able to greatly suppress the increase of the amount of processing and detect scratches or other defects on the surface of the object being inspected by a suitable resolution and able to judge the states of formation of films on the surface of that object.

### MEANS FOR SOLVING THE PROBLEMS

The visual inspection system according to the present invention is configured having an imaging unit comprised of a plurality of line sensors with different color sensitivity characteristics arranged in parallel at predetermined intervals, scanning a surface of an object being inspected, and outputting density signals for the pixels from the line sensors and a processing unit generating information expressing the state of the surface of the object based on the density signals from the line sensors in the imaging unit, the processing unit having a pixel data acquiring means acquiring pixel density data from a density signal from a single reference line sensor determined from the plurality of line sensors by a first pixel density and acquiring pixel density data from the density signals from the line sensors other than the reference line sensor by a second pixel density lower than the first pixel density and generating information expressing the state of the surface of the object based on the pixel density data acquired by the first pixel density and the pixel density data acquired by the second pixel density.

Due to this configuration, information showing the state of the object surface is generated based on pixel density data acquired from a density signal for each pixel from the reference line sensor among the plurality of line sensors by the first pixel density and pixel density data acquired from density signals for each pixel from the line sensors other than the reference line sensor by the second pixel density, so it is possible to obtain density information due to scratches or other defects of the object surface or the presence of films (state of object surface) based on the pixel density data of the relatively high definition (first pixel density) acquired from the density signal from the reference line sensor. Further, it is possible to obtain information of the color distribution due to the state of formation of films at the object surface (state of object surface) based on pixel density data corresponding to the plurality of colors of pixel density data obtained by the second pixel density giving a relatively low definition from the density signals from the line sensors other than the reference line sensor and pixel density data obtained from the density signal from the reference line sensor.

Further, in the visual inspection system according to the present invention, the plurality of line sensors include three line sensors having color sensitivity characteristics of the three primary colors of light (red, green, and blue), and the line sensor having the green color sensitivity characteristic is arranged at the center of the three line sensors.

Furthermore, the line sensor having the green sensitivity characteristic can be configured arranged on the optical axis of the camera.

Due to this configuration, if selecting the linear sensor having a green color sensitivity characteristic as the reference line sensor, it is possible to obtain more suitable density information due to the scratches or other defects of the object surface or the presence of films (state of object surface) based on the pixel density data acquired by the first pixel density giving a relatively high definition from the density signal of that reference line sensor.

Further, the visual inspection system according to the present invention may be configured having the object being inspected be a semiconductor wafer, having the plurality of line sensors arranged to extend in a direction substantially vertical to the surface of the semiconductor wafer, and making the semiconductor wafer turn about an axis vertical to that surface so as to scan a peripheral end face of the semiconductor wafer.

Due to this configuration, it is possible to obtain density information due to scratches or other defects of the peripheral end face of the semiconductor wafer or the presence of films (state of object surface) based on the pixel density data acquired from the density signal from the reference line sensor by a first pixel density giving a relatively high definition and it is possible to obtain color distribution information due to the state of formation of films at the peripheral end face of the semiconductor wafer (state of object surface) based on the pixel density data corresponding to the plurality of color characteristics of the image density data acquired from the density signals from the line sensors other than the reference line sensors by a second pixel density giving a relatively low definition and image density data obtained from the density signal from the reference line sensor.

Further, the visual inspection system according to the present invention may be configured having a selecting means for selecting the reference line sensor from the plurality of line sensors.

Due to this configuration, for example, if selecting a line sensor giving a sensitivity characteristic of the color close to a complementary color of the color of the film being particularly noted as a reference line sensor, it is possible to obtain density information able to more suitably express the presence of film being noted at the object surface based on the pixel density data acquired by the first pixel density giving a relatively high definition from the reference line sensor.

Further, the visual inspection system according to the present invention may be configured so that the imaging unit outputs a color signal expressing the color for each pixel based on the density signals from the plurality of line sensors and the processing unit generates information showing the state of the object surface based on the color signal.

Due to this configuration, information expressing the state of the surface of the object being inspected based on a color signal showing the color for each pixel output from the imaging unit is generated, so even without synthesizing pixel density data based on the density signals from the three line sensors, it is possible to easily generate image data able to express the image of the surface of an object.

Note that the imaging unit can generate a color signal showing the color (frequency) for each pixel by for example converting the density signals from the line sensors to frequency information based on the extents of the densities and color sensitivity characteristics.

Further, the visual inspection system according to the present invention may be configured so that the processing unit has a pixel color data acquiring means acquiring pixel color data from the color signal by the second pixel density and generates information showing the state of an object surface based on pixel color data acquired by the second pixel density.

Due to this configuration, pixel color data is acquired from the color signal for each pixel output from the imaging unit by the relatively low definition second pixel density, so it is possible to keep the amount of processing when generating image data able to express the image of the surface of an object relatively low.

Further, the visual inspection system according to the present invention is configured having an imaging unit comprised of a plurality of line sensors with different color sensitivity characteristics arranged in parallel at predetermined intervals, scanning a surface of an object being inspected, and outputting a density signal for each pixel from the line sensors and a processing unit generating information expressing the state of the surface of the object based on the density signals from the line sensors in the imaging unit, the processing unit having a pixel data acquiring means acquiring pixel density data while shifting the scan line of each line sensor by a predetermined number of lines each time after skipping a predetermined number of lines from a density signal for each pixel from the plurality of line sensors and generating information expressing the state of the surface of the object based on the pixel density data after skipping a predetermined number of lines acquired corresponding to the line sensors.

Due to this configuration, pixel density data is acquired from the density signals for each pixel of the plurality of line sensors after skipping a predetermined number of scan lines, so it becomes possible to reduce the amount of processing compared with obtaining pixel density data for all of the scan lines. Further, the pixel density data is acquired while shifting the scan line of each line sensor by a predetermined number of lines each time, so it is possible to greatly reduce the scan lines from which pixel density data is not acquired from any line sensor, so it is possible to greatly suppress deterioration of image quality.

EFFECTS OF THE INVENTION

According to the visual inspection system according to the present invention, it is possible to obtain density information due to scratches or other defects and the presence of films on the surface of an object based on the pixel density data acquired from the density signal from the reference line sensor by the first pixel density giving a relatively high definition, so it is possible to detect scratches or other defects on the surface of the object from that density information by a suitable resolution (corresponding to first pixel density). Further, simultaneously, to obtain information of the color distribution dependent on the state of formation of the films on the surface of the object, it is sufficient to acquire pixel density data from the density signals from the line sensors other than the reference line sensor by a second pixel density giving a relatively low definition, so that amount of processing can be greatly suppressed. Therefore, it is possible to greatly suppress the increase of the amount of processing and detect scratches or other defects of the surface of the object being inspected by a suitable resolution and possible to judge the state of formation of films on the surface of the object.

BRIEF DESCRIPTION OF THE DRAWINGS

[FIG. 1] is a view showing the configuration of a visual inspection system according to an embodiment of the present invention.

[FIG. 2] gives a plan view (a) showing the positional relationship between three line sensors in a CCD camera in the visual inspection system shown in FIG. 1 and a semiconductor wafer forming the object being inspected, a side view (b) showing the positional relationship between the three line sensors and a peripheral end face of a semiconductor wafer, and a front view (c) showing the positional relationship between the three line sensors and the lens of the CCD camera.

[FIG. 3] is a plan view showing the positional relationship between the three line sensors and the lens of the CCD camera in more detail.

[FIG. 4] is a flowchart showing the processing routine at the processing unit in the visual inspection system shown in FIG. 1.

[FIG. 5] is a flowchart showing the processing for scanning the peripheral end face in the flowchart shown in FIG. 4.

[FIG. 6] gives a view (a) showing the pixel density data obtained by a second pixel density (corresponding to a low resolution) and a view (b) showing the resolution in color expression.

[FIG. 7] is a flowchart showing the color image processing in the flowchart shown in FIG. 4.

[FIG. 8] a view showing another method of acquiring pixel density data of each color component and a method of generating color image data from the pixel density data of each color component acquired.

[FIG. 9] is a flowchart showing a processing routine at a processing unit at the time of generating color image data in accordance with the method shown in FIG. 8.

[FIG. 10] is a view showing examples (a) and (b) of the characteristics of the outputs of the line sensors.

[FIG. 11] is a view showing the state of arranging a light blocking plate near the semiconductor wafer being inspected in the visual inspection system.

[FIG. 12] is a view showing the arrangement of the top slanted surface of the peripheral end of the semiconductor wafer being inspected and the CCD camera in the system shown in FIG. 11.

[FIG. 13] is a view showing the relationship between the color components and defects.

[FIG. 14] is a view showing an example of graphing the color components.

[FIG. 15] is a view showing an example of displaying defects discriminated based on color components on the image.

DESCRIPTION OF NOTATIONS

| 10 | wafer rotary aligner |
|----|----------------------|
| 11 | turntable |
| 20 | CCD camera |
| 21 | lens system |
| 22R | red line sensor |
| 22G | green line sensor |
| 22B | blue line sensor |
| 30 | light source unit |
| 31 | power source |
| 50 | processing unit |
| 51 | operating unit |
| 52 | monitor unit |
| 100 | semiconductor wafer |
| 101 | peripheral end face |
| 102 | top slanted surface |
| 120 | light blocking plate |

BEST MODE FOR CARRYING OUT THE INVENTION

Below, embodiments of the present invention will be explained based on the drawings

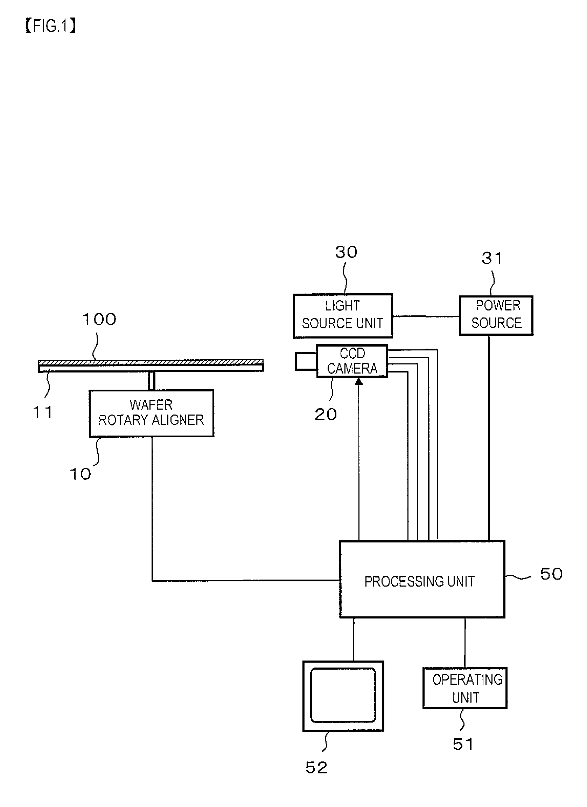

The visual inspection system according to an embodiment of the present invention is configured as shown in FIG. 1. This visual inspection system inspects the external appearance of the peripheral end face of a semiconductor wafer.

In FIG. 1, this visual inspection system has a wafer rotary aligner 10. The wafer rotary aligner 10 turns a turntable 11 on which an object to be inspected, that is, a semiconductor wafer 100, is set. Further, a CCD camera 20 forming an imaging unit is set so as to become a predetermined positional relationship with respect to the peripheral end face of the semiconductor wafer 100 set on the turntable 11, and a light source unit 30 emitting diffused light by the supply of power from a power source 31 is set so as to irradiate the peripheral end face of the semiconductor wafer 100 falling in the range of capture of the CCD camera 20 by the diffused light.

Further, this visual inspection system has a processing unit 50. The processing unit 50 controls the wafer rotary aligner 10 based on the operation at the operating unit 51 to make the turntable 11 turn by a predetermined speed and processes the signal for each pixel output from the CCD camera 20. The processing unit 50 can make a monitor unit 52 display an image of the peripheral end face of the semiconductor wafer 100 based on the image data generated based on the signal of each pixel from the CCD camera 20.

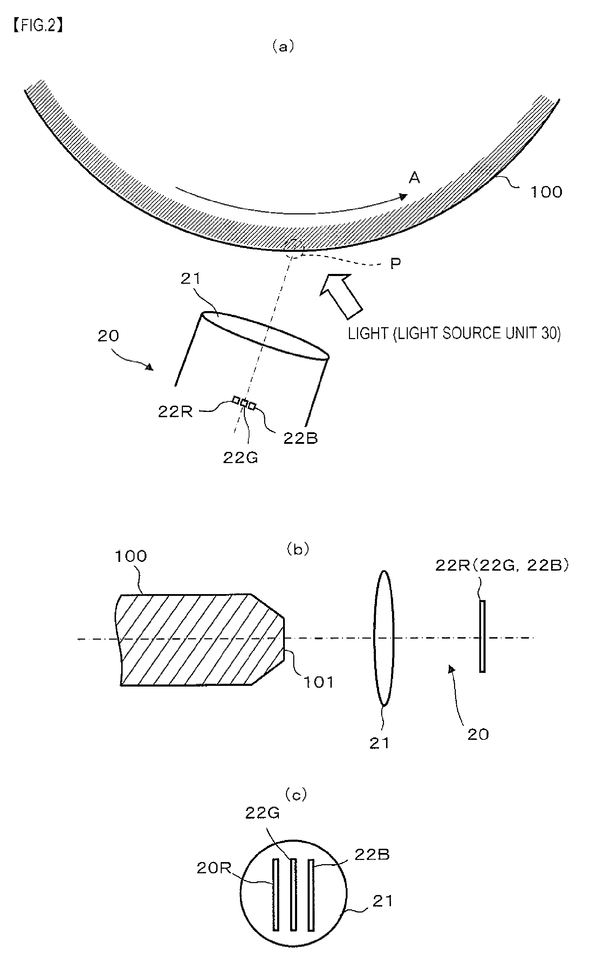

The CCD camera 20, as shown in FIGS. 2(a), (b), and (c), is provided with a lens system 21 (object lens) and three line sensors (CCD line sensors) having color sensitivity characteristics of the three primary colors (red, green, and blue) respectively, that is, a red line sensor 22R having a red color sensitivity characteristic, a green line sensor 22G having a green color sensitivity characteristic, and a blue line sensor 22B having a blue color sensitivity characteristic. The three line sensors 22R, 22G, and 22B, as shown in FIGS. 2(a) and (c), are arranged in parallel at predetermined intervals. The CCD camera 20, as shown in FIG. 2(b), is comprised of three line sensors 22R, 22G, and 22B arranged so as to face the peripheral end face 101 of the semiconductor wafer 100 so as to extend in the direction substantially vertical to the surface of the semiconductor wafer 100 (vertical surface). Further, the orientation of the CCD camera 20, as shown in FIG. 2(a), is set so as to enable light reflected from the light irradiated portion P of the peripheral end face 101 of the semiconductor wafer 100 irradiated by light from the light source unit 30 to be effectively received by the three line sensors 22R, 22G, and 22B.

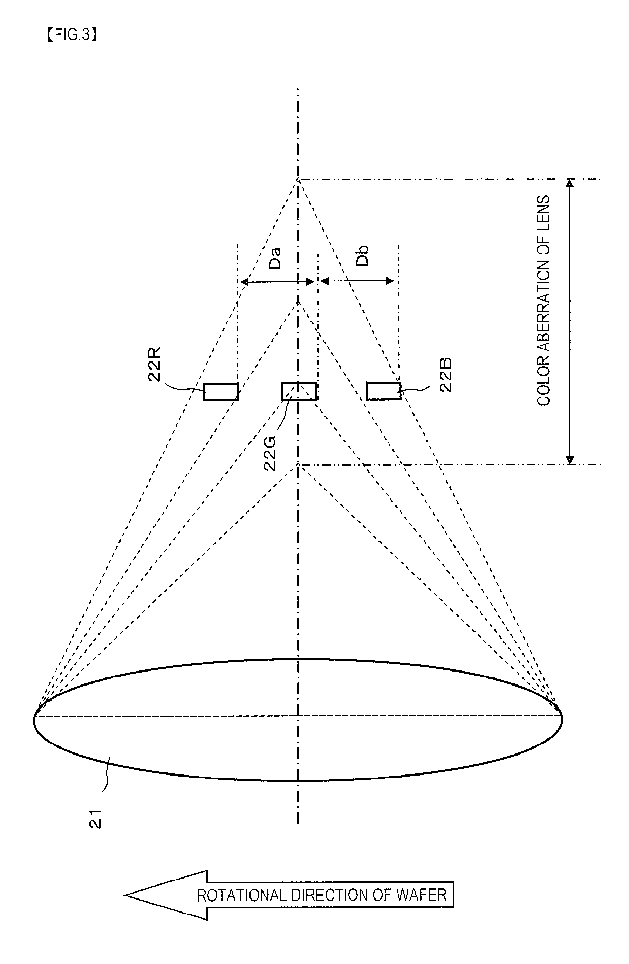

Further, as shown in detail in FIG. 3, the green line sensor 22G is arranged on the optical axis of the lens system 21 (optical axis of CCD camera 20), the red line sensor 22R is arranged at one side across a distance Da, and the blue line sensor 22B is arranged at the other side across a distance Db. Furthermore, the three line sensors 22R, 22G, and 22B are arranged so as to be in the color aberration of the lens system 21.

By turning the turntable 11 and thereby turning the semiconductor wafer 100, the line sensors 22R, 22G, and 22B of the CCD camera 20 scan the peripheral end face of the semiconductor wafer 100 and output density signals for each pixel in the process of that scan. Further, the CCD camera 20 converts the density signal from the red line sensor 22R (below, referred to as the "R signal"), the density signal from the green line sensor 22G (below, referred to as the "G signal"), and the density signal from the blue line sensor 22B (below, referred to as the "B signal") to frequency information based on the degree of that density and color sensitivity characteristic and thereby outputs a color signal expressing the color (frequency) for each pixel (below, referred to as the "RGB signal"). This RGB signal corresponds to the signal output from a single plate type color line sensor.

The CCD processing unit 50 receiving as input the R signal, G signal, B signal, and RGB signal output from the camera 20 performs the following processing.

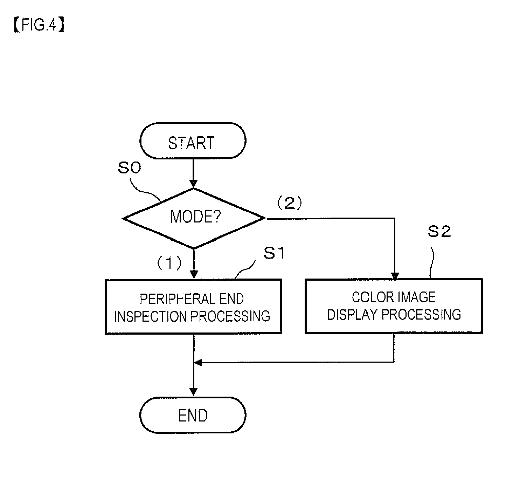

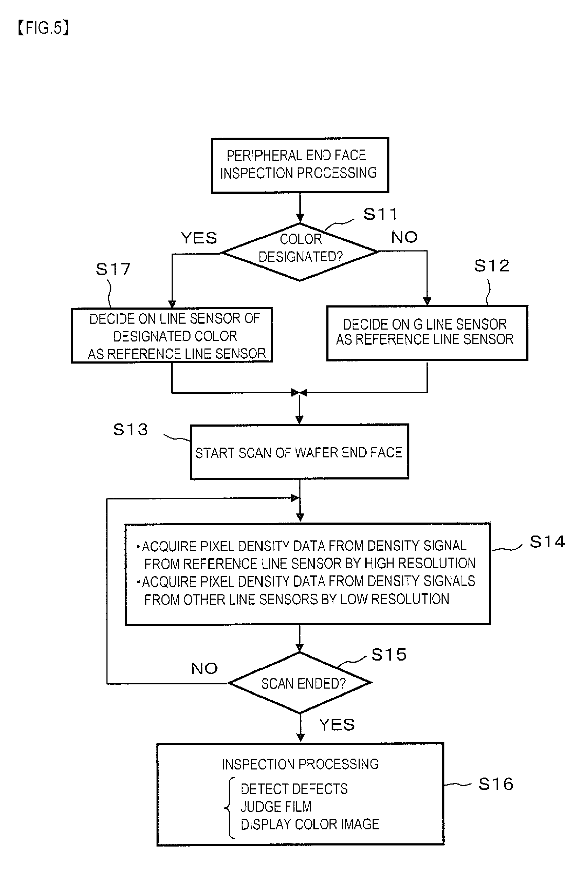

As shown in FIG. 4, the processing unit 50 judges the mode set by an operation at the operating unit 51 (S0). For example, when the mode (1) according to the inspection of the peripheral end face is set, the processing unit 50 executes the processing for scanning the peripheral end face (S1). This processing for scanning the peripheral end face is performed in accordance with the routine shown in FIG. 5.

In FIG. 5, the processing unit 50 judges if an operation has been performed at the operating unit 51 for designating a color (S11). When no operation is performed for designating the color (NO at S11), the processing unit 50 determines the green line sensor 22G as the reference line sensor (S12) and controls the wafer rotary aligner 10 to turn the semiconductor wafer 100 and thereby start the scan of the peripheral end face of the semiconductor wafer 100 by the CCD camera 20 (S13). In the process of scanning that peripheral end face, the processing unit 50 acquires pixel density data (G) from the G signal for each pixel from the reference line sensor (green line sensor 22G) by first pixel density corresponding to a high resolution and stores it in a predetermined memory and acquires pixel density data (R) and pixel density data (B) from the R signal and B signal for each pixel from the red line sensor 22R and blue line sensor 22B by a second pixel density corresponding to a low resolution and stores them in the memory (S14). Furthermore, the processing unit 50 repeats the processing (S14) judging if the semiconductor wafer 100 has made one turn and the entire circumference of the end face has finished being scanned (S15).

The first pixel density corresponding to a high resolution is for example determined based on the pixel density of the reference line sensor (green line sensor 22G) forming the pixel density in the main scan direction Sm (for example, 1 pixel/3 $\mu$m) and the scan line density corresponding to the pixel pitch of the reference line sensor forming the pixel density of the sub scan direction Ss (peripheral direction of semiconductor wafer 100) (for example, 1 line/3 $\mu$m). Further, the pixel density data (R) and (B) are acquired from the R signal and B signal from the red line sensor 22R and blue line sensor 22B, for example, at the ratio of one pixel for three pixels for the main scan direction Sm and at the ratio of one line for three lines for the sub scan direction Ss. In this case, the second pixel density corresponding to a low resolution becomes substantially 1/9 of the first pixel density corresponding to a high resolution.

If the processing unit 50 judges that the scan of the entire circumference of the end face of the semiconductor wafer 100 has ended (YES at S15), it executes the scan processing using the pixel density data (G) acquired by the first pixel density and stored in the memory and the pixel density data (R) and pixel density data (B) acquired by the second pixel density (1/9 of first pixel density) and stored in the memory (S16). In this scan processing, defect detection processing, film judgment processing, image processing of the color image, etc. are performed.

In defect detection processing, from the viewpoint of detecting as fine scratches or other defects as possible, density image data showing the state of the peripheral end face of the semiconductor wafer 100 is generated based on the pixel density data (G) acquired by the first pixel density (corresponding to a high resolution). Furthermore, based on that density image data, processing is performed for detecting scratches or other defects of the peripheral end face of the semiconductor wafer 100. This is done by the method of, for example, the processing unit 50 deeming pixel parts having a density value of a preset threshold value or more or the present threshold value or less as a defect.

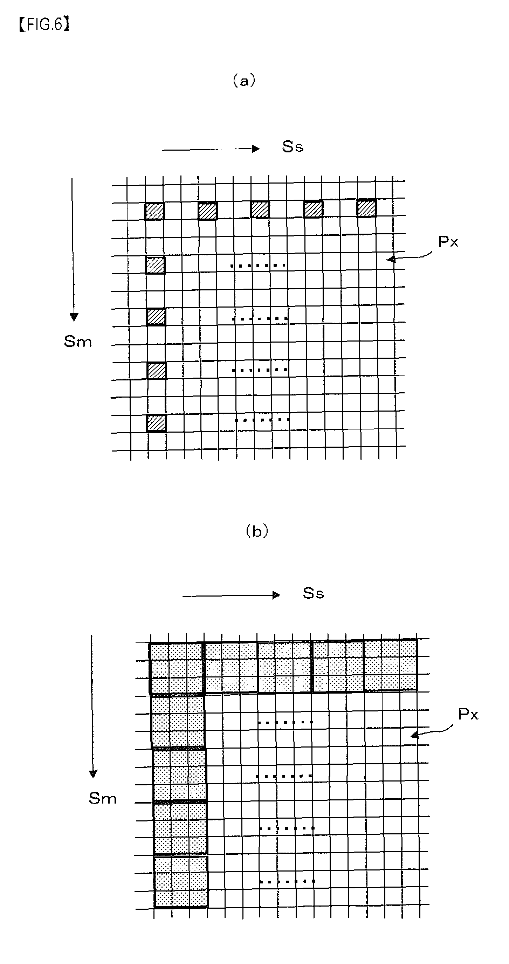

In the film judgment processing, information of the color distribution of the resolution for every nine pixels (corresponding to a low resolution) as shown by the hatched squares of FIG. 6(b) is generated based on pixel density data (R) corresponding to red and pixel density data (B) corresponding to blue obtained by the second pixel density (corresponding to a low resolution) and pixel density data (G) corresponding to green for the pixels Px obtained by the pixel density data (R) and (B) (pixel density data corresponding to the three primary colors of light) as shown by the hatched squares of FIG. 6(a). The state of formation of films at the peripheral end face of the semiconductor wafer 100 able to be discriminated by the tint is judged based on the color distribution information and the pixel density data (G) obtained by the first pixel density (corresponding to a high resolution) able to show the scratches or other defects of the peripheral end face of the semiconductor wafer 100 and the state of the films formed on the peripheral end face (in this case as well, processing based on threshold value is similar to detection of defects). Specifically, for example, it is possible to judge the state where a bluish nitride film is partially peeled off and the underlying aluminum film is exposed or the state where a reddish Cu film is attached or to judge the state of uneven coating of a resist based on an uneven color.

In the above way, even if the information of the color distribution is a low resolution (resolution of 1/9 the density image data showing the density, see FIG. 6), the shape of the film formed on the peripheral end face of the semiconductor wafer 100 is specified by the high resolution (corresponding to the first pixel density). This does not form any particular problem in judging the state of formation of films able to be discriminated by the tint.

In the image processing of the color image, based on the pixel density data (G), (R), and (B) corresponding to the plurality of color components of the pixel density data (G) acquired by the first pixel density (corresponding to a high resolution) and the pixel density data (R) and pixel density data (B) acquired by the second pixel density (corresponding to a low resolution), color image data showing the state of the peripheral end face of the semiconductor wafer 100 is generated by the pixel density corresponding to the display resolution of the monitor unit 52 (in general, lower than the above resolution) . Furthermore, the color image of the peripheral end face of the semiconductor wafer 100 is displayed on the monitor unit 52 based on that color image data. The operator can observe the color image of this monitor unit 52 and thereby judge to a certain extent the state of scratches or other defects of the peripheral end face of the semiconductor wafer 100 and the state of formation of films based on the color distribution.

Note that in the processing routine shown in FIG. 5, when it is judged that the color has been designated by the operating unit 51 (YES at S11), the processing unit 50 determines the line sensor of the designated color (color sensitivity characteristic) as the reference line sensor (S17). Furthermore, after this, the above-mentioned processing (S13 to S16) is executed.

In this case, for example, if selecting the line sensor giving a sensitivity characteristic of a color close to a complementary color of the color of the film being particularly noted as the reference line sensor, it becomes possible to generate density image data able to more suitably express the presence of a film being noted at the peripheral end face of the semiconductor wafer 100 based on the pixel density data acquired from the reference line sensor by the first pixel density giving a relatively high definition.

According to the above-mentioned processing for scanning the peripheral end face, it is possible to obtain density image data due to scratches or other defects or the presence of films at the peripheral end face of the semiconductor wafer 100 based on the pixel density data acquired from the density signal from a reference line sensor (for example, green line sensor 22G) by a first pixel density corresponding to a high resolution, so it becomes possible to detect scratches or other defects of the peripheral end face of the semiconductor wafer 100 from that density image data by a suitable resolution (corresponding to first pixel density). Further, simultaneously, to obtain information of the color distribution able to express the state of formation of films on the peripheral end face of the semiconductor wafer 100, it is sufficient to acquire pixel density data from density signals from the line sensors other than the reference line sensor (for example, red line sensor 22R and blue line sensor 22B) by a second pixel density corresponding to a low resolution. It is possible to greatly suppress the amount of processing and required memory capacity. Therefore, it becomes possible to greatly keep down the increase of the amount of processing and detect scratches or other defects of the peripheral end face of a semiconductor wafer 100 by a suitable resolution and becomes possible to judge the state of formation of the different types of film able to be differentiated by the tint of the peripheral end face.

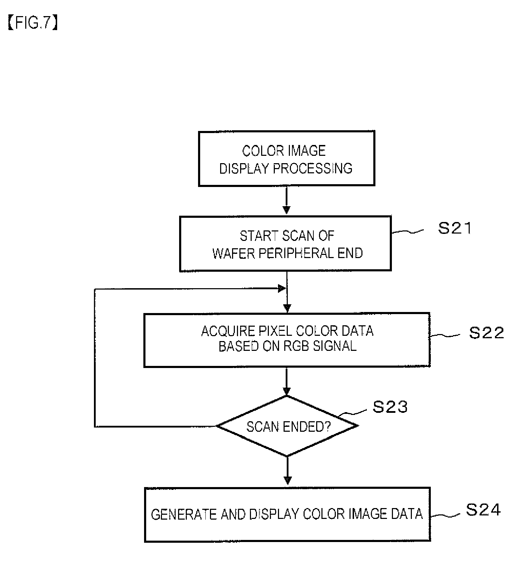

Note that in the processing routine shown in FIG. 4, if the operating unit 51 is used to set the mode (2) relating to color image display, the processing unit 50 executes color image processing (S2). This color image processing is performed in accordance with the routine shown in FIG. 7.

In FIG. 7, if the scan of the peripheral end face of the semiconductor wafer 100 by the CCD camera unit 20 is started (S21), in the process of scanning that peripheral end face, the processing unit 50 acquires pixel color data by the second pixel density corresponding to a low resolution from the RGB signal (color signal) output from the CCD camera 20 and stores it in a predetermined memory (S22). Furthermore, the processing unit 50 repeatedly executes the processing (S22) judging if the semiconductor wafer 100 has made one turn and the entire circumference of the end face has finished being scanned (S23).

If the processing unit 50 judges that the entire circumference of the end face of the semiconductor wafer 100 has finished being scanned (YES at S23), the processing unit 50 generates color image data showing the state of the peripheral end face of the semiconductor wafer 100 based on the pixel color data acquired by the second pixel density and stored in the memory. Furthermore, the processing unit 50 makes the monitor unit 52 display the color image of the peripheral end face of the semiconductor wafer 100 based on the color image data (S24). The operator examines the color image of this monitor unit 52 and can judge to a certain extent the state of scratches and other defects on the peripheral end face of the semiconductor wafer 100 and the state of formation of films based on the color distribution.

According to the image processing of the color image, color image data showing the state of the peripheral end face of the semiconductor wafer 100 is generated based on the RGB signals showing the colors of each pixel output from the CCD camera 20, so it is possible to easily generate image data able to express the image of the peripheral end face even without synthesizing the pixel density data based on the density signals from the three line sensors 22R, 22G, and 22B.

Note that in the above-mentioned example, a single CCD provided with three line sensors having color sensitivity characteristics of the three primary colors of light was used as an imaging unit, but it is possible to use three CCD cameras 20 individually provided with line sensors as the imaging unit. In that case, it is also possible to set the pixel densities of the line sensors other than the reference line sensor physically lower than the pixel density of the reference line sensor.

In the above-mentioned example, the peripheral end face 101 of the semiconductor wafer 100 (see FIG. 2(b)) was inspected, but it is also possible to inspect other surfaces of the semiconductor wafer 100, for example, the top side slanted surface and bottom side slanted surface connected to the peripheral end face 101 (see FIG. 2(b)). Further, it is also possible to inspect other objects in addition to a semiconductor wafer 100.

It is also possible to generate color image data in the following way from the density signals (R signal, G signal, and B signal) from the three line sensors 22R, 22G, and 22B.

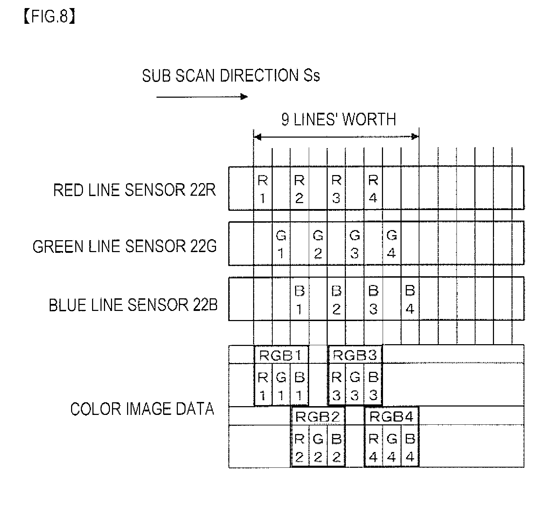

In this example, as shown in FIG. 8, pixel density data corresponding to the color components (R, G, and B) are generated from the R signal, G signal, and B signal of the red line sensor 22R, green line sensor 22G, and blue line sensor 22B while shifting the scan lines of the line sensors 22R, 22G, and 22B by one line at a time in the sub scan direction Ss after skipping one scan line each. That is, from the R signal of the red line sensor 22R, the pixel density data R1, R2, R3, R4, ... is generated in the sub scan direction Ss after skipping one scan line each; from the G signal of the green line sensor 22G, the pixel density data G1, G2, G3, G4, ... is generated in the sub scan direction Ss skipping one scan line each; and, further, from the B signal from the blue line sensor 22B, the pixel density data B1, B2, B3, B4, ... is generated in sub scan direction Ss after skipping one scan line each. The pixel density data G1, G2, G3, G4, ... corresponding to green (G) are shifted by one line with respect to the pixel density data R1, R2, R3, R4, ... corresponding to red (R), while the pixel density data B1, B2, B3, B4, ... corresponding to blue (B) are shifted by one line with respect to the pixel density data G1, G2, G3, G4, ... corresponding to green (G). Furthermore, one line worth of color image data RGB1, RGB2, ... is generated by the three scan lines' worth of pixel density data (R1, G1, B1), (R2, G2, B2), ... of the different color components.

If trying to obtain the color image data in this way, the pixel density data of each color component is generated after skipping one line each, so for example, as shown in FIG. 8, to obtain nine lines' worth of color image data, compared with the total number of scans by the conventional three line sensors of 27 lines (3×9 lines), the total number of scans can be kept to 12 lines (3×4 lines). Therefore, it is possible to reduce the amount of processing of that information. Further, the pixel density data is obtained while shifting the scan line by one line at a time for each of the line sensors 22R, 22G, and 22B, that is, the color components, so there is no scan line where pixel density data cannot be acquired for any color component. It becomes possible to obtain pixel density data for at least one of the color components at each scan line. Therefore, the image obtained based on the obtained color image data is one greatly suppressed in deterioration of image quality.

As a result, it becomes possible to suppress the increase of the amount of processing and judge scratches or other defects (state of appearance) of the surface of the object and the state of formation of films (state of tint) from the obtained color image data without problem.

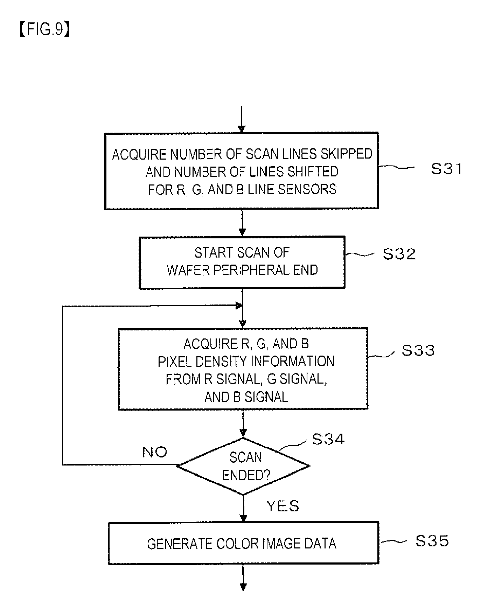

The processing unit 50 (see FIG. 1) executes the processing for obtaining the color image data from the density signals (R signal, G signal, and B signal) from the three line sensors 22R, 22G, and 22B as explained above in accordance with the routine shown in for example FIG. 9.

In FIG. 9, if the number of scan lines skipped (for example, 1 line) and the number of scan lines shifted (1 line) for all of the line sensors 22R, 22G, and 22B are input from the operating unit 51 operated by an operator, the processing unit 50 acquires the number of scan lines skipped and the number of scan lines shifted (S33). Furthermore, the processing unit 50 controls the wafer rotary aligner 10 to make the semiconductor wafer 100 rotate and start the scan of the peripheral end face of the semiconductor wafer 100 by the CCD camera 20 (S32). In the process of scanning that peripheral end face, the processing unit 50 generates pixel density data of the color components while shifting the scan line for each color component by the acquired number of lines (for example 1 line) from the density signals (R signal, G signal, and B signal) from the line sensors 22R, 22G, and 22B after skipping the acquired number of skipped scan lines (for example, after skipping one scan line each) (see FIG. 8) and stores it in the memory (S33). Furthermore, the processing unit 50 repeatedly executes the processing (S33) judging if the semiconductor wafer 100 has made one turn and the entire circumference of the end face has finished being scanned (S34). When the entire circumference of the end face of the semiconductor wafer 100 finishes being scanned (YES at S34), the processing unit 50 successively generates one line's worth of color image data RGB1, RGB2, ... by the three scan lines' worth of pixel density data (R1, G1, B1), (R2, G2, B2), ... of the different color components from the pixel density data of the color components stored in the memory up to that time (S35).

Next, the special feature in mounting the line sensors 22R, 22G, and 22B will be explained.

In general, a line sensor of a CCD (charge coupled device) cannot recognize an element not receiving light or other excitation energy. For example, the area beyond a not operating element is not scanned. Therefore, when the line sensors 22R, 22G, and 22B, for example, have 8000 pixels and are driven by a scan rate of about 5 kHz, it is possible to leave 2000 pixels able to capture the end face of the semiconductor wafer 100 being inspected and prevent the other 6000 pixels from receiving light by a metal or other light blocking plate. In this case, the line sensors 22R, 22G, and 22B of the CCD can no longer recognize 6000 pixels' worth of elements and are driven by a scan rate of 20 kHz by the effective 2000 pixels.

In general,

$$\text{operation processing speed}$$
$$= (\text{number of pixels} - \text{number of blocked pixels})/\text{number of clocks}$$
$$= \text{number of effective pixels}/\text{number of clocks} = \text{scan rate}$$

When using lines sensors of numbers of pixels greater than the number of pixels required for inspection (number of devices), it is possible to block the light from the excess pixels in line with the above formula so as to improve the operating rate.

It is possible to adjust the CCD camera 20 as follows considering the distortion of the lens 21 at the CCD camera 20 etc.

First, the relative position of the semiconductor wafer 100 covered with respect to the CCD camera 20 is adjusted. This adjustment can be performed by adjusting the wafer rotary aligner 10 at which the semiconductor wafer 100 is set.

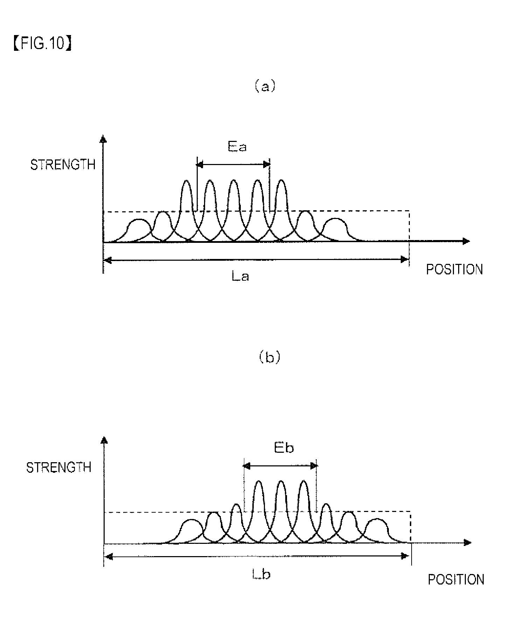

Line sensors of numbers of pixels greater than the numbers of pixels covering the range of capture are used and the shadings of the line sensors, depth of field of the lens 21, and focal distance are adjusted. After that, the image captured by that CCD camera 20 is checked and regions of use of the line sensors are set in regions where no distortion of the lens 21 occurs. For example, with a line sensor where the effective length becomes La obtained from the image signal as shown in FIG. 10(a), that usage region Ea is set, while with a line sensor where the effective length becomes Lb obtained from the signal as shown in FIG. 10(b), the usage region Eb is set. Specifically, information of the pixel positions corresponding to the usage regions Ea and Eb are set in the processing unit 50. Due to this, the processing unit 50 handles just the density signals from that usage regions Ea and Eb as signals to be processed.

By adjusting the CCD camera 20 in this way, even if there was distortion in the lens 21, it becomes possible to obtain good pixel density data for all color components without the effect of that distortion.

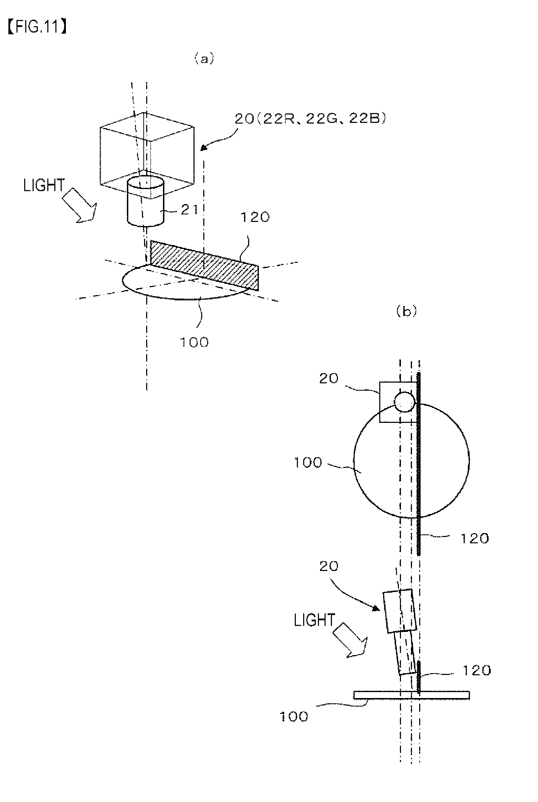

Furthermore, when using a CCD camera 20 having three lines of line sensors 22R, 22G, and 22B (three plate type), there is greater susceptibility to disturbance light compared with a CCD camera of a single line sensor (single plate type). Therefore, the effect of disturbance light easily appears in the obtained image. From the viewpoint of greatly reducing the effect of this disturbance light, as shown in FIGS. 11(a) and (b), it is possible to provide a light blocking plate 120.

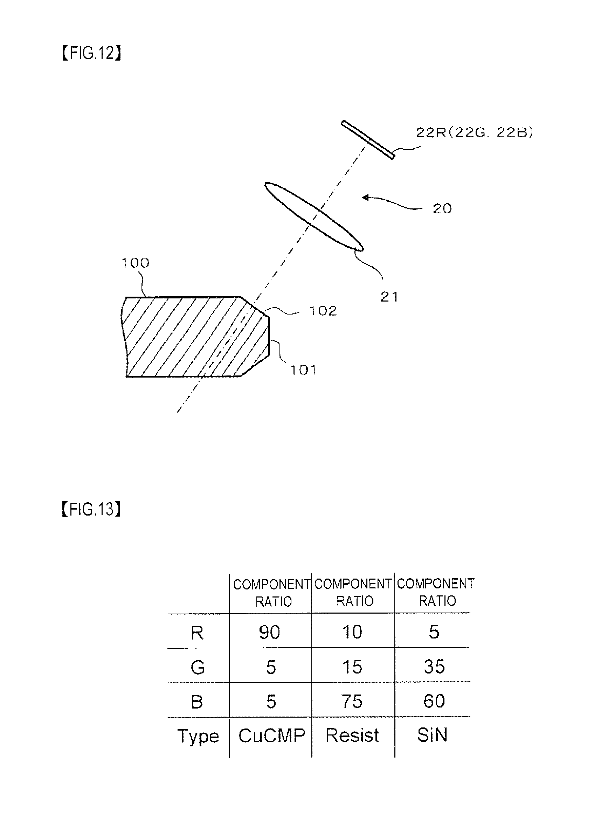

In this example, as shown in FIG. 12, the top slanted surface 102 of the peripheral end of the semiconductor wafer 100 is captured by the CCD camera 20. In this case, as shown in FIGS. 11(a) and (b), the light blocking plate 120 is arranged to cut across the semiconductor wafer 100 being inspected in the diametrical direction. Further, the CCD camera 20 is oriented toward the top slanted surface 10 of the peripheral end of the semiconductor wafer 100 being captured in the state slightly slanted from the vertical direction. Further, the illumination use diffused light is emitted toward the imaging portion from the CCD camera 20 side of the light blocking plate 120. By providing such a light blocking plate 120, disturbance light from the reverse side to the CCD camera 20 across the light blocking plate 120 is prevented from entering the CCD camera 20, so it is possible to reduce the effect of the disturbance light on the obtained image.

Next, the ratio of color components obtained from the pixel density data R, G, and B can be used as the parameter for evaluation of a region.

For example, as shown in FIG. 13, it is possible to store the correspondence between the color component ratio and defects in advance and display information showing the corresponding defects for a region of that color component or a color component close to that color component on the monitor unit 52. If doing this, the operator can easily judge what kind of defect is included in the inspected object.

Note that in the example shown in FIG. 13, the case of a ratio of red (R):green (G):blue (B) components of 90:5:5 is linked with a working defect (Cu residue) of the copper (Cu) in the CMP step, the case of the same component ratio of 10:15:75 is linked with defects (cracks) of the resist, and the case of the same component ratio of 5:35:60 is linked with defects of the SiN layer.

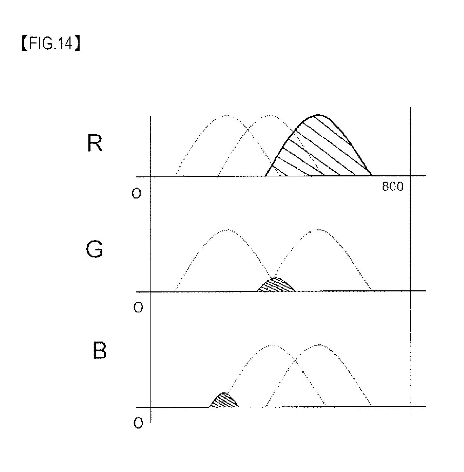

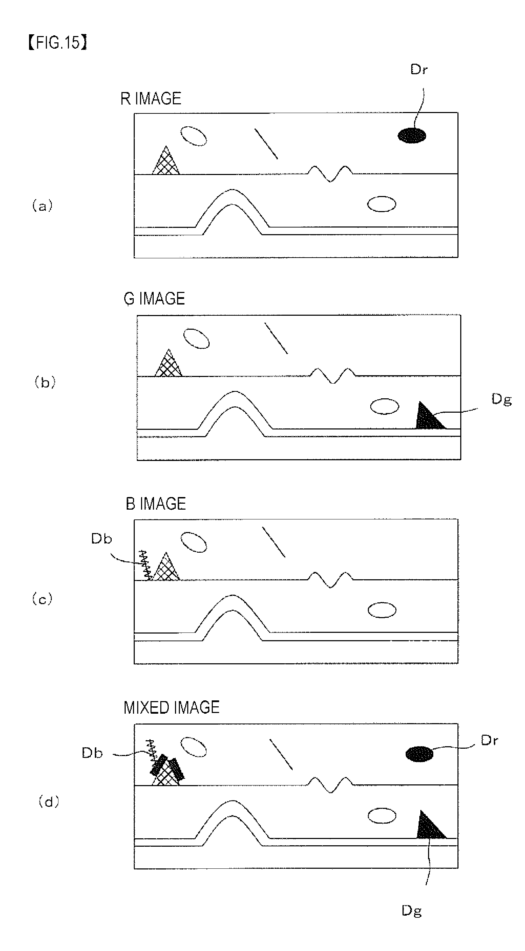

Further, it is also possible to prepare a graph of the color component ratio of the pixels forming the region as shown in FIG. 14 and present it to the operator and, further, to display an image to enable the defect region to be understood as shown in FIG. 15. In the case of the example shown in FIG. 15, the region Dr of the ratio of red (R):green (G):blue (B) components shown in FIG. 13 of 90:5:5 (see FIG. 15(a)) is shown enhanced at the image based on the red (R) pixel density data as a residual Cu or other R defect. Further, the region Db of the same component ratio of 10:15:75 (see FIG. 15(c)) is shown enhanced at the image based on the blue (B) pixel density data as a defect of the resist (cracks etc.) or other B defect. Furthermore, the region Db of the same component ratio of 5:35:60 (see FIG. 15(b)) is shown enhanced at the image based on the green (G) pixel density data as a defect of the SiN layer or other G defect. Further, in a color image based on color image data obtained by combining the R pixel density data, G pixel density data, and B pixel density data, the regions Dr, Dg, and Db are displayed enhanced as defect regions. Due to this, the operator can easily judge what kind of defect region is included in the object inspected from the displayed image.

INDUSTRIAL APPLICABILITY

As explained above, there is the effect that the visual inspection system according to the present invention can greatly keep down the increase of the amount of processing and detect scratches or other defects of the surface of an object being inspected by a suitable resolution and can judge the state of formation of films on that object surface. This is effective as a visual inspection system for inspecting the appearance of the surface of an object being inspected such as a peripheral end face of a semiconductor wafer.

FIG. 1

10. WAFER ROTARY ALIGNER
20. CCD CAMERA
30. LIGHT SOURCE UNIT
31. POWER SOURCE
50. PROCESSING UNIT
51. OPERATING UNIT

FIG. 2

LIGHT (LIGHT SOURCE UNIT 30)

FIG. 3

COLOR ABERRATION OF LENS
ROTATIONAL DIRECTION OF WAFER

FIG. 4

START

S0. MODE?
S1. PERIPHERAL END INSPECTION PROCESSING
S2. COLOR IMAGE DISPLAY PROCESSING

END

FIG. 5

PERIPHERAL END FACE INSPECTION PROCESSING

S11. COLOR DESIGNATED?
S12. DECIDE ON G LINE SENSOR AS REFERENCE LINE SENSOR
S13. START SCAN OF WAFER END FACE
S14. · ACQUIRE PIXEL DENSITY DATA FROM DENSITY SIGNAL FROM REFERENCE LINE SENSOR BY HIGH RESOLUTION
· ACQUIRE PIXEL DENSITY DATA FROM DENSITY SIGNALS FROM OTHER LINE SENSORS BY LOW RESOLUTION
S15. SCAN ENDED?
S16. INSPECTION PROCESSING
DETECT DEFECTS
JUDGE FILM
DISPLAY COLOR IMAGE
S17. DECIDE ON LINE SENSOR OF DESIGNATED COLOR AS REFERENCE LINE SENSOR

FIG. 7

# EP 1 959 251 A1

COLOR IMAGE DISPLAY PROCESSING

S21. START SCAN OF WAFER PERIPHERAL END
S22. ACQUIRE PIXEL COLOR DATA BASED ON RGB SIGNAL
S23. SCAN ENDED?
S24. GENERATE AND DISPLAY COLOR IMAGE DATA

FIG. 8

SUB SCAN DIRECTION Ss
9 LINES' WORTH
RED LINE SENSOR 22R
GREEN LINE SENSOR 22G
BLUE LINE SENSOR 22B
COLOR IMAGE DATA

FIG. 9

S31. ACQUIRE NUMBER OF SCAN LINES SKIPPED AND NUMBER OF LINES SHIFTED FOR R, G, AND B LINE SENSORS
S32. START SCAN OF WAFER PERIPHERAL END
S33. ACQUIRE R,G, AND B PIXEL DENSITY INFORMATION FROM R SIGNAL, G SIGNAL, AND B SIGNAL
S34. SCAN ENDED?
S35. GENERATE COLOR IMAGE DATA

FIG. 10

STRENGTH
POSITION
STRENGTH
POSITION

FIG. 11

LIGHT
LIGHT

FIG. 13

COMPONENT RATIO
COMPONENT RATIO
COMPONENT RATIO

FIG. 15

R IMAGE
G IMAGE
B IMAGE
MIXED IMAGE

## Claims

1. A visual inspection system having
an imaging unit comprised of a plurality of line sensors with different color sensitivity characteristics arranged in parallel at predetermined intervals, scanning a surface of an object being inspected, and outputting density signals for the pixels from the line sensors and
a processing unit generating information expressing the state of the surface of the object based on the density signals from the line sensors in the imaging unit,

the processing unit having a pixel data acquiring means acquiring pixel density data from a density signal from a single reference line sensor determined from the plurality of line sensors by a first pixel density and acquiring pixel density data from the density signals from the line sensors other than the reference line sensor by a second pixel density lower than the first pixel density and

generating information expressing the state of the surface of the object based on the pixel density data acquired by the first pixel density and the pixel density data acquired by the second pixel density.

2. A visual inspection system as set forth in claim 1, **characterized in that** said plurality of line sensors include three line sensors having color sensitivity characteristics of the three primary colors of light (red, green, and blue), and the line sensor having the green color sensitivity characteristic is arranged at the center of said three line sensors.

3. A visual inspection system as set forth in claim 2, **characterized in that** said line sensor having a green sensitivity characteristic is arranged on an optical axis of said camera.

4. A visual inspection system as set forth in claim 1, **characterized by** having the object being inspected be a semiconductor wafer, having said plurality of line sensors arranged to extend in a direction substantially vertical to the surface of said semiconductor wafer, and making said semiconductor wafer turn about an axis vertical to that surface so as to scan a peripheral end face of said semiconductor wafer.

5. A visual inspection system as set forth in claim 1, **characterized by** having a selecting means for selecting said reference line sensor from said plurality of line sensors.

6. A visual inspection system as set forth in claim 1, **characterized in that**
said imaging unit outputs a color signal expressing the color for each pixel based on the density signals from said plurality of line sensors and
said processing unit generates information showing the state of the object surface based on said color signal.

7. A visual inspection system as set forth in claim 6, **characterized in that**
said processing unit has a pixel color data acquiring means acquiring pixel color data from said color signal by said second pixel density and
generates information showing said state of object surface based on pixel color data acquired by said second pixel density.

8. A visual inspection system having
an imaging unit comprised of a plurality of line sensors with different color sensitivity characteristics arranged in parallel at predetermined intervals, scanning a surface of an object being inspected, and outputting a density signal for each pixel from the line sensors and
a processing unit generating information expressing the state of the surface of the object based on the density signals from the line sensors in the imaging unit,
the processing unit having a pixel data acquiring means acquiring pixel density data while shifting the scan line of each line sensor by a predetermined number of lines each time after skipping a predetermined number of lines from a density signal for each pixel from the plurality of line sensors and
generating information expressing the state of the surface of the object based on the pixel density data after skipping a predetermined number of lines acquired corresponding to the line sensors.

【FIG.1】

【FIG.2】

(a)

100

A

P

21

20

22R

22G

22B

LIGHT (LIGHT SOURCE UNIT 30)

(b)

100

101

21

22R(22G, 22B)

20

(c)

22G

20R

22B

21

【FIG.3】

Da

Db

22R

22G

22B

COLOR ABERRATION OF LENS

21

ROTATIONAL DIRECTION OF WAFER

【FIG.4】

【FIG.5】

```
          ┌─────────────────────────────┐
          │   PERIPHERAL END FACE       │
          │   INSPECTION PROCESSING     │
          └─────────────────────────────┘
                        │
                        ▼              S11
         YES      ◇─────────────◇      NO
      ┌───────────│    COLOR    │───────────┐
  S17 │           │ DESIGNATED? │           │ S12
      │            ◇───────────◇            │
      ▼                                     ▼
┌───────────────────────────┐   ┌───────────────────────────┐
│ DECIDE ON LINE SENSOR OF  │   │  DECIDE ON G LINE SENSOR  │
│    DESIGNATED COLOR       │   │  AS REFERENCE LINE SENSOR │
│ AS REFERENCE LINE SENSOR  │   │                           │
└───────────────────────────┘   └───────────────────────────┘
             │                               │
             └───────────────┬───────────────┘
                             ▼
  S13      ┌─────────────────────────────────────┐
           │   START SCAN OF WAFER END FACE       │
           └─────────────────────────────────────┘
                             │
        ┌────────────────────┤
        │                    ▼
        │  ┌─────────────────────────────────────────────┐
        │  │ ·ACQUIRE PIXEL DENSITY DATA FROM DENSITY      │  S14
        │  │  SIGNAL FROM REFERENCE LINE SENSOR BY HIGH    │
        │  │  RESOLUTION                                   │
        │  │ ·ACQUIRE PIXEL DENSITY DATA FROM DENSITY      │
        │  │  SIGNALS FROM OTHER LINE SENSORS BY LOW       │
        │  │  RESOLUTION                                   │
        │  └─────────────────────────────────────────────┘
        │                    │
        │         NO         ▼              S15
        └────────────◇───────────────◇
                     │  SCAN ENDED?  │
                      ◇─────────────◇
                             │ YES
                             ▼
           ┌─────────────────────────────────────┐
           │      INSPECTION PROCESSING          │  S16
           │   ┌ DETECT DEFECTS                  │
           │   ┤ JUDGE FILM                      │
           │   └ DISPLAY COLOR IMAGE             │
           └─────────────────────────────────────┘
```

【FIG.6】

(a)

(b)

【FIG.7】

```
┌──────────────────────┐
│     COLOR IMAGE      │
│  DISPLAY PROCESSING  │
└──────────────────────┘
            │
            ▼
┌──────────────────────┐
│     START SCAN OF    │ ── S21
│ WAFER PERIPHERAL END │
└──────────────────────┘
            │
    ┌──────►│
    │       ▼
    │  ┌──────────────────────┐
    │  │  ACQUIRE PIXEL COLOR DATA │ ── S22
    │  │   BASED ON RGB SIGNAL │
    │  └──────────────────────┘
    │           │
    │           ▼
    │       ◇──────────◇
    └────── │ SCAN ENDED? │ ── S23
            ◇──────────◇
                │
                ▼
┌────────────────────────────────┐
│ GENERATE AND DISPLAY COLOR IMAGE DATA │ ── S24
└────────────────────────────────┘
```

【FIG.8】

SUB SCAN DIRECTION Ss

9 LINES' WORTH

RED LINE SENSOR 22R

| R 1 | R 2 | R 3 | R 4 |

GREEN LINE SENSOR 22G

| G 1 | G 2 | G 3 | G 4 |

BLUE LINE SENSOR 22B

| B 1 | B 2 | B 3 | B 4 |

COLOR IMAGE DATA

| RGB1 | | | RGB3 | | |
| R 1 | G 1 | B 1 | R 3 | G 3 | B 3 |

| RGB2 | | | RGB4 | | |
| R 2 | G 2 | B 2 | R 4 | G 4 | B 4 |

【FIG.9】

```
              │
              ▼
┌─────────────────────────────────────┐
│  ACQUIRE NUMBER OF SCAN LINES SKIPPED│
│     AND NUMBER OF LINES SHIFTED      │──── S31
│     FOR R, G, AND B LINE SENSORS     │
└─────────────────────────────────────┘
              │
              ▼
    ┌────────────────────────┐
    │     START SCAN OF       │──── S32
    │  WAFER PERIPHERAL END   │
    └────────────────────────┘
              │
     ┌────────▼─────────────────┐
     │  ┌─────────────────────┐ │
     │  │  ACQUIRE R, G, AND B  │
     │  │ PIXEL DENSITY INFORMATION │──── S33
     │  │  FROM R SIGNAL, G SIGNAL, │
     │  │     AND B SIGNAL     │
     │  └─────────────────────┘
     │            │
     │            ▼        S34
     │         ◇ SCAN ◇
     │   NO    ◇ ENDED? ◇
     └─────────◇      ◇
                   │ YES
                   ▼
        ┌────────────────────────┐
        │ GENERATE COLOR IMAGE DATA │──── S35
        └────────────────────────┘
                   │
                   ▼
```

【FIG.10】

(a)

STRENGTH

Ea

La

POSITION

(b)

STRENGTH

Eb

Lb

POSITION

【FIG.11】

(a)

20(22R、22G、22B)

LIGHT

21

120

100

(b)

20

100

120

20

LIGHT

120

100

【FIG.12】

【FIG.13】

|      | COMPONENT RATIO | COMPONENT RATIO | COMPONENT RATIO |
|------|------|------|------|
| R | 90 | 10 | 5 |
| G | 5 | 15 | 35 |
| B | 5 | 75 | 60 |
| Type | CuCMP | Resist | SiN |

【FIG.14】

【FIG.15】

R IMAGE

Dr

(a)

G IMAGE

(b)

Dg

B IMAGE

Db

(c)

MIXED IMAGE

Db

Dr

(d)

Dg

**INTERNATIONAL SEARCH REPORT**

| International application No. |
|---|
| PCT/JP2006/324198 |

A. CLASSIFICATION OF SUBJECT MATTER
*G01N21/956*(2006.01)i, *H01L21/66*(2006.01)i, *H04N5/335*(2006.01)i

According to International Patent Classification (IPC) or to both national classification and IPC

B. FIELDS SEARCHED

Minimum documentation searched (classification system followed by classification symbols)
G01N21/84-21/958, H01L21/64-21/66, H04N5/30-5/335, H04N1/04-1/20

Documentation searched other than minimum documentation to the extent that such documents are included in the fields searched
| Jitsuyo Shinan Koho | 1922-1996 | Jitsuyo Shinan Toroku Koho | 1996-2007 |
| Kokai Jitsuyo Shinan Koho | 1971-2007 | Toroku Jitsuyo Shinan Koho | 1994-2007 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | JP 2-214265 A (Canon Inc.),<br>27 August, 1990 (27.08.90),<br>Page 2, lower left column, line 12 to page 4,<br>upper left column, line 9; Figs. 1 to 2<br>(Family: none) | 1,6-7<br>2-5 |
| X | JP 5-56218 A (Ricoh Co., Ltd.),<br>05 March, 1993 (05.03.93),<br>Par. Nos. [0022] to [0039]; Figs. 1 to 8<br>(Family: none) | 1,6-7 |
| Y | JP 5-22615 A (Minolta Camera Co., Ltd.),<br>29 January, 1993 (29.01.93),<br>Par. Nos. [0021] to [0025]; Fig. 3<br>(Family: none) | 2-5 |

☒ Further documents are listed in the continuation of Box C.  ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 02 March, 2007 (02.03.07) | 13 March, 2007 (13.03.07) |

| Name and mailing address of the ISA/ | Authorized officer |
|---|---|
| Japanese Patent Office | |
| Facsimile No. | Telephone No. |

Form PCT/ISA/210 (second sheet) (April 2005)

**INTERNATIONAL SEARCH REPORT**

International application No.

PCT/JP2006/324198

| C (Continuation). | DOCUMENTS CONSIDERED TO BE RELEVANT | |
|---|---|---|
| Category* | Citation of document, with indication, where appropriate, of the relevant passages | Relevant to claim No. |
| Y | JP 2003-139523 A (Nippon Electro-Sensory Devices Corp.), 14 May, 2003 (14.05.03), Par. Nos. [0024] to [0040]; Figs. 1 to 5 (Family: none) | 4 |
| X | JP 11-127321 A (Fuji Xerox Co., Ltd.), 11 May, 1999 (11.05.99), Par. Nos. [0012] to [0030]; Figs. 1 to 4 (Family: none) | 8 |

Form PCT/ISA/210 (continuation of second sheet) (April 2005)

**EP 1 959 251 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2000114329 A